# EUROPEAN PATENT APPLICATION

(11) **EP 4 079 509 A1**
(43) Date of publication of application: **26.10.2022**
(21) Application number: 22168553.0
(22) Date of filing: 14.04.2022
(51) Int. Cl.: B32B 5/20, B32B 15/04, B32B 15/18, B32B 15/20, C09D 179/08, H05K 1/03

(54) **POROUS POLYIMIDE FILM**

(30) Priority: 19.04.2021 JP 2021070658; 01.02.2022 JP 2022014324
(71) Applicant: Nitto Denko Corporation, Ibaraki-shi, Osaka 567-8680 (JP)
(72) Inventor: MISHIMA, Kei, Osaka, 567-8680 (JP)
(74) Representative: Gill Jennings & Every LLP

(57) **Abstract**

[Problem]

To provide a porous polyimide film capable of suppressing an increase in a dielectric loss tangent even when immersed in water.

[Solving Means]

In a porous polyimide film, a difference between a dielectric loss tangent T1 after being left to stand for 24 hours under an atmosphere of 25°C and relative humidity of 50% and a dielectric loss tangent T2 after immersion in water for 24 hours under an atmosphere of 25°C is 0.0030 or less.

## Description

### TECHNICAL FIELD

The present invention relates to a porous polyimide film.

### BACKGROUND ART

A porous polyimide film which is formed from a reaction product of a diamine component and an acid dianhydride component has been known (ref: for example, Patent Document 1 below). In Example of Patent Document 1, the diamine component contains a phenylenediamine (PDA) and an oxydianiline (ODA).

### Citation List

### Patent Document

Patent Document 1: WO2018/186486

### SUMMARY OF THE INVENTION

### PROBLEM TO BE SOLVED BY THE INVENTION

The porous polyimide film is immersed in water in accordance with its application and purpose. The porous polyimide film is required to suppress an increase in a dielectric loss tangent even when immersed in water.

However, the porous polyimide film described in Patent Document 1 has a problem that the above-described demand cannot be satisfied.

The present invention provides a porous polyimide film which is capable of suppressing an increase in a dielectric loss tangent even when immersed in water.

### MEANS FOR SOLVING THE PROBLEM

The present invention (1) includes a porous polyimide film having a difference between a dielectric loss tangent T1 after immersion in water for 24 hours under an atmosphere of 25°C and a dielectric loss tangent T2 after being left to stand for 24 hours under an atmosphere of 25°C and relative humidity of 50% of 0.0030 or less.

The present invention (2) includes the porous polyimide film described in (1) having the dielectric loss tangent T2 of 0.0060 or less.

The present invention (3) includes the porous polyimide film described in (1) or (2), wherein a judgement in a flame retardancy test according to the UL94 standard is V-0 or more.

### EFFECT OF THE INVENTION

In the porous polyimide film of the present invention, the difference between the dielectric loss tangent T2 after immersion in water and the dielectric loss tangent T1 after being left to stand in an atmosphere is 0.0030 or less. Therefore, it is possible to suppress an increase in the dielectric loss tangent even when the porous polyimide film is immersed in water.

### BRIEF DESCRIPTION OF THE DRAWINGS

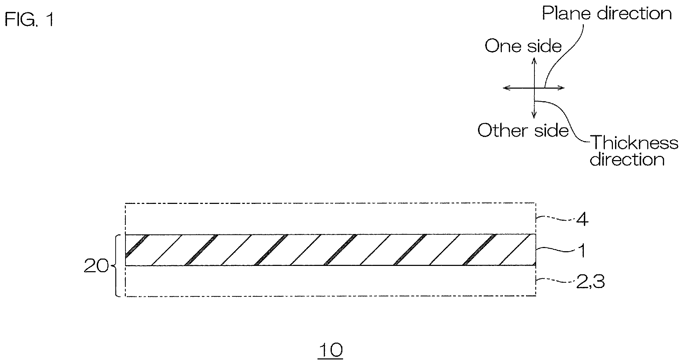

FIG. 1 shows a cross-sectional view of one embodiment of a porous polyimide film of the present invention.

### DESCRIPTION OF EMBODIMENTS

### <Porous Polyimide Film>

A porous polyimide film of the present invention is described. The porous polyimide film has a thickness. The porous polyimide film extends in a plane direction. The plane direction is perpendicular to a thickness direction.

The porous polyimide film is porous. The porous polyimide film has, for example, a closed-cell structure and/or an open cell structure. The porous polyimide film preferably has a closed-cell structure from the viewpoint of reliably suppressing an crease in a dielectric loss tangent T2 after immersion in water.

### <Dielectric Loss Tangent T1 of Porous Polyimide Film after Being Left to Stand in Atmosphere >

A dielectric loss tangent T1 of the porous polyimide film after being left to stand for 24 hours under an atmosphere of 25°C and relative humidity of 50% is not limited. The start of being left to stand is not limited. Specifically, the start of being left to stand may be immediately after production of the porous polyimide film, or may be at the time of obtainment of the circulating porous polyimide film.

Since the above-described dielectric loss tangent T1 of the porous polyimide film is a dielectric loss tangent for obtaining a reference for determining a difference from the dielectric loss tangent T2 after immersion in water for "24 hours" to be described later, the settling time is set as the same "24 hours" as the 24 hours which are the measurement time of the dielectric loss tangent 2.

A dielectric loss tangent T0 immediately after production or at the time of obtainment, that is, the dielectric loss tangent T0 before being left to stand for 24 hours is substantially the same as the dielectric loss tangent T1 after being left to stand for 24 hours. Specifically, it is possible to suppress a difference between the dielectric loss tangent T0 before being left to stand and the dielectric loss tangent T1 after being left to stand at, for example, 0.0001 or less, furthermore 0.00001 or less.

The dielectric loss tangent T1 of the porous polyimide film after being left to stand for 24 hours under an atmosphere of 25°C and relative humidity of 50% is adjusted so that a difference to be described later is a desired upper limit or less. Specifically, the dielectric loss tangent T1 of the porous polyimide film after being left to stand for 24 hours under an atmosphere of 25°C and relative humidity of 50% is, for example, 0.0028 or less, preferably 0.0025 or less, more preferably 0.0020 or less, further more preferably 0.0015 or less, particularly preferably 0.0010 or less, most preferably 0.0008 or less. A lower limit of the dielectric loss tangent T1 after being left to stand under an atmosphere is not limited. The dielectric loss tangent T1 after being left to stand under an atmosphere is, for example, above 0.0000, furthermore, 0.0001 or more.

The dielectric loss tangent T1 of the porous polyimide film after being left to stand is measured at 10 GHz using a resonator. Further, the same is applied to measurement of the above-described dielectric loss tangent T0.

<Dielectric Loss Tangent T2 of Porous Polyimide Film after Immersion in Water>

The dielectric loss tangent T2 of the porous polyimide film after immersion in water for 24 hours under an atmosphere of 25°C is not limited. The above-described dielectric loss tangent T2 of the porous polyimide film after immersion in water is adjusted so that a difference of the dielectric loss tangent to be described next is a desired upper limit or less. The start of immersion may be immediately after production of the porous polyimide film, or may be at the time of obtainment of the circulating porous polyimide film. Specifically, preferably, the above-described dielectric loss tangent T2 of the porous polyimide film after immersion in water for 24 hours under an atmosphere of 25°C is, for example, 0.0060 or less, preferably 0.0050 or less, more preferably 0.0040 or less, further more preferably 0.0038 or less, particularly preferably 0.0030 or less, most preferably 0.0025 or less, furthermore 0.0020 or less. A lower limit of the dielectric loss tangent T2 of the porous polyimide film after immersion in water is not limited. The dielectric loss tangent T2 of the porous polyimide film after immersion in water is, for example, above 0.0000, furthermore 0.0001 or more.

### <Difference between Two Dielectric Loss Tangents of Porous Polyimide Film>

In the present invention, a difference between the above-described dielectric loss tangent T1 after being left to stand for 24 hours under an atmosphere of 25°C and relative humidity of 50% and the above-described dielectric loss tangent T2 after immersion in water for 24 hours under an atmosphere of 25°C is 0.0030 or less.

When the above-described difference of the dielectric loss tangent is above 0.0030, it is not possible to sufficiently suppress an increase in the dielectric loss tangent of the porous polyimide film when the porous polyimide film is immersed in water.

Since the dielectric loss tangent tends to increase at the time of immersion of the porous polyimide film in water, the above-described difference of the dielectric loss tangent is represented by a value (T2- T1) obtained by subtracting the dielectric loss tangent T1 after being left to stand under an atmosphere from the dielectric loss tangent T2 after immersion in water.

The above-described difference of the dielectric loss tangent is preferably 0.0025 or less, more preferably 0.0018 or less.

A lower limit of the above-described difference of the dielectric loss tangent is not limited. The above-described difference is, for example, above 0.0000, furthermore 0.0001 or more, 0.001 or more, 0.0013 or more, 0.0015 or more.

### <Properties Other Than Dielectric Loss Tangent>

A dielectric constant at 10 GHz of the porous polyimide film is not limited. The porous polyimide film has a dielectric constant at 10 GHz of, for example, 2.50 or less, preferably 2.00 or less, more preferably 1.80 or less, further more preferably 1.75 or less, particularly preferably 1.70 or less, most preferably 1.60 or less. When the dielectric constant of the porous polyimide film is the above-described upper limit or less, it is preferably used for, for example, wireless communication of the fifth generation (5G) standard, and/or a high-speed flexible printed board (FPC) as the porous polyimide film having a low dielectric constant. Further, the dielectric constant at 10 GHz of the porous polyimide film is above 1.00. The dielectric constant of the porous polyimide film is measured using a resonator.

A porosity of the porous polyimide film is not limited. The porous polyimide film has a porosity of, for example, 50% or more, preferably 60% or more, more preferably 65% or more, and for example, 95% or less, preferably 80% or less, more preferably 70% or less. When the porosity of the porous polyimide film is the above-described lower limit or more, it is possible to reduce the two dielectric constants. When the porosity of the porous polyimide film is the above-described upper limit or less, mechanical strength of the porous polyimide film is ensured, and handling properties are excellent.

The porosity of the porous polyimide film is determined by insertion of the dielectric constant into the following formula.

Dielectric constant of porous polyimide film= dielectric constant of air× porosity+ dielectric constant of polyimide resin× (1- porosity)

The porous polyimide film has an average pore size of, for example, 10 µm or less, preferably 5 µm or less, and for example, 0.1 µm or more, preferably 1 µm or more, more preferably 2 µm or more. The average pore size is measured by image analysis of a cross-sectional SEM image.

A judgement when the porous polyimide film is subjected to a flame retardancy test according to the flame retardancy UL94 standard is, for example, V-2 or more, preferably V-1 or more, more preferably V-0. When the judgement of the flame retardancy test is the above-described reference or more, the porous polyimide film has excellent flame retardancy.

A thickness of the porous polyimide film is not limited. The porous polyimide film has a thickness of, for example, 2 µm or more, preferably 5 µm or more, and for example, 1000 µm or less, preferably 500 µm or less.

### <Raw Material for Porous Polyimide Film>

The porous polyimide film is, for example, a reaction product of a diamine component and an acid dianhydride component. In other words, a raw material for the porous polyimide film contains, for example, a diamine component and an acid dianhydride component.

### <Diamine Component>

The diamine component contains an aromatic diamine and/or an aliphatic diamine. The aromatic diamine and/or the aliphatic diamine are/is main components in the diamine component.

### <Aromatic Diamine>

The aromatic diamine is represented by the following formula (1). 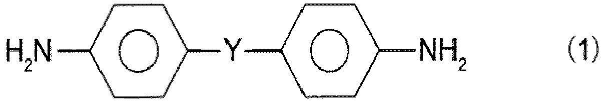 (In formula, Y represents at least one selected from the group consisting of a single bond, -COO-, -S-, -CH(CH₃)-, -C(CH₃)₂-, -CO-, -NH-, and -NHCO-.)

<Kind of Aromatic Diamine>

Specifically, examples of the diamine component include 4,4'-diaminodiphenyl in which Y is a single bond, 4-aminophenyl-4-aminobenzoate in which Y is -COO-, bis(4-aminophenyl)sulfide in which Y is -S-, 4,4'-diaminodiphenylethane in which Y is -CH(CH₃)-, 4,4'-diaminodiphenyl propane in which Y is -C(CH₃)₂-, 4,4'-diaminobenzophenone in which Y is -CO-, 4,4'-diaminophenyleneamine in which Y is -NH-, and 4,4'-diaminobenzoanilide in which Y is -NHCO-. Preferably, from the viewpoint of further lowering a difference of the dielectric loss tangent of the porous polyimide film, a 4-aminophenyl-4-aminobenzoate is used. The 4-aminophenyl-4-aminobenzoate may be simply abbreviated as APAB. The above-described aromatic diamines may be used alone or in combination. Preferably, from the viewpoint of further lowering the above-described difference of the dielectric loss tangent and improving the flame retardancy, APAB is used alone.

A mole fraction of the aromatic diamine in the diamine component is, for example, 5 mol% or more, preferably 10 mol% or more, more preferably 15 mol% or more, and for example, 75 mol% or less, preferably 60 mol% or less, more preferably 40 mol% or less.

### <Aliphatic Diamine>

The aliphatic diamine may include a cyclic portion in a molecule, while including a long-chain alkyl group. Examples of the aliphatic diamine include hexamethylenediamine, 1,3-bis(aminomethyl)cyclohexanes, and dimer diamine. As the aliphatic diamine, preferably, a dimer diamine is used. The dimer diamine is, for example, an amine compound in which two carboxyl groups possessed by a dimer acid are substituted with a primary amino group. The dimer acid is a dimer of an unsaturated fatty acid. An example of the unsaturated fatty acid includes an oleic acid. The dimer diamine is, for example, described in Japanese Unexamined Patent Publications No. 2020-172667, and 2018-168369. As the dimer diamine, a commercially available product may be used, and specifically, the PRIAMINE series (manufactured by Croda International Plc) is used.

A mole fraction of the aliphatic diamine in the diamine component is, for example, 5 mol% or more, preferably 10 mol% or more, more preferably 15 mol% or more, and for example, 75 mol% or less, preferably 50 mol% or less, more preferably 30 mol% or less.

An aromatic diamine and an aliphatic diamine may be used in combination, an aromatic diamine may be used alone, or an aliphatic diamine may be used alone. Preferably, an aromatic diamine is used alone, preferably, an aliphatic diamine is used alone.

### <Another Diamine Component>

The diamine component may contain, for example, a second aromatic diamine and a third aromatic diamine in addition to the aromatic diamine and/or the aliphatic diamine described above. The second aromatic diamine and the third aromatic diamine are secondary components in the diamine component.

### <Second Aromatic Diamine>

The second aromatic diamine includes a single aromatic ring. Examples of the second aromatic diamine include phenylenediamine, dimethylbenzenediamine, and ethylmethylbenzenediamine. From the viewpoint of mechanical strength, preferably, a phenylenediamine is used. Examples of the phenylenediamine include o-phenylenediamine, m-phenylenediamine, and p-phenylenediamine. As the phenylenediamine, preferably, a p-phenylenediamine is used. The p-phenylenediamine may be simply abbreviated as PDA.

A mole fraction of the second aromatic diamine in the diamine component is, for example, 10 mol% or more, preferably 20 mol% or more, and for example, 95 mol% or less, preferably 75 mol% or less, more preferably 65 mol% or less.

### <Third Aromatic Diamine>

The third aromatic diamine includes a plurality of aromatic rings and an ether bond or a single bond disposed between them. Examples of the third aromatic diamine include oxydianiline and diaminodimethylbiphenyl (also known as tolidine). Examples of the oxydianiline include 3,4'-oxydianiline, and 4,4'-oxydianiline. Examples of the diaminodimethylbiphenyl include 4,4'-diamino-2,2'-dimethylbiphenyl (also known as m-tolidine) and 4,4'-diamino-3,3'-dimethylbiphenyl (also known as o-tolidine). From the viewpoint of lowering the above-described difference of the dielectric loss tangent and from the viewpoint of improving the flame retardancy, preferably, an oxydianiline is used, more preferably, a 4,4'-oxydianiline (also known as 4,4'-diaminodiphenyl ether) is used. The 4,4'-oxydianiline may be simply abbreviated as ODA.

A mole fraction of the third aromatic diamine in the diamine component is, for example, 5 mol% or more, preferably 10 mol% or more, and for example, 95 mol% or less, preferably 30 mol% or less.

A second aromatic diamine and a third aromatic diamine may be used in combination, a second aromatic diamine may be used alone, or a third aromatic diamine may be used alone. Preferably, a second aromatic diamine and a third aromatic diamine are used in combination.

In addition, the total parts by mole of the aromatic diamine and the aliphatic diamine described above (preferably, part by mole of the aromatic diamine or the aliphatic diamine) with respect to 100 parts by mole of the total sum of the second aromatic diamine and the third aromatic diamine is, for example, 5 parts by mole or more, preferably 10 parts by mole or more, more preferably 20 parts by mole or more, and for example, 100 parts by mole or less, preferably 50 parts by mole or less, more preferably 30 parts by mole or less.

### <Acid Dianhydride Component>

The acid dianhydride component contains, for example, an acid dianhydride including an aromatic ring. An example of the acid dianhydride including an aromatic ring includes an aromatic tetracarboxylic acid dianhydride. Examples of the aromatic tetracarboxylic acid dianhydride include benzenetetracarboxylic acid dianhydride, benzophenone tetracarboxylic acid dianhydride, biphenyltetracarboxylic acid dianhydride, biphenylsulfone tetracarboxylic acid dianhydride, and naphthalenetetracarboxylic acid dianhydride.

An example of the benzenetetracarboxylic acid dianhydride includes a benzene-1,2,4,5-tetracarboxylic acid dianhydride. An example of the benzophenone tetracarboxylic acid dianhydride includes a 3,3'-4,4'-benzophenone tetracarboxylic acid dianhydride and a 2,2'-3,3'-benzophenone tetracarboxylic acid dianhydride. Examples of the biphenyltetracarboxylic acid dianhydride include 3,3'-4,4'-biphenyltetracarboxylic acid dianhydride, 2,2'-3,3'-biphenyltetracarboxylic acid dianhydride, 2,3,3',4'-biphenyltetracarboxylic acid dianhydride, and 3,3',4,4'-diphenylethertetracarboxylic acid dianhydride. An example of the biphenylsulfone tetracarboxylic acid dianhydride includes a 3,3',4,4'-biphenylsulfone tetracarboxylic acid dianhydride. Examples of the naphthalenetetracarboxylic acid dianhydride include 2,3,6,7-naphthalenetetracarboxylic acid dianhydride, 1,2,5,6-naphthalenetetracarboxylic acid dianhydride, 1,2,4,5-naphthalenetetracarboxylic acid dianhydride, and 1,4,5,8-naphthalenetetracarboxylic acid dianhydride.

As the acid dianhydride component, from the viewpoint of mechanical strength, preferably, a benzenetetracarboxylic acid dianhydride and a biphenyltetracarboxylic acid dianhydride are used, more preferably, a benzene-1,2,4,5-tetracarboxylic acid dianhydride and a 3,3'-4,4'-biphenyltetracarboxylic acid dianhydride are used. Since the benzene-1,2,4,5-tetracarboxylic acid dianhydride is also referred to as a pyromellitic acid dianhydride, it may be simply abbreviated as PMDA. The 3,3'-4,4'-biphenyltetracarboxylic acid dianhydride may be simply abbreviated as BPDA.

These acid dianhydride components may be used alone or in combination. Preferably, a benzenetetracarboxylic acid dianhydride is used alone, preferably, a benzenetetracarboxylic acid dianhydride and a biphenyltetracarboxylic acid dianhydride are used in combination. More preferably, BPDA is used alone, more preferably, BPDA and PMDA are used in combination.

When a benzenetetracarboxylic acid dianhydride and a biphenyltetracarboxylic acid dianhydride are used in combination, a part by mole of the biphenyltetracarboxylic acid dianhydride with respect to 100 parts by mole of the benzenetetracarboxylic acid dianhydride is, for example, 5 parts by mole or more, preferably 10 parts by mole or more, more preferably 20 parts by mole or more, and for example, 200 parts by mole or less, preferably 100 parts by mole or less, more preferably 50 parts by mole or less, further more preferably 30 parts by mole or less.

A mole amount of amino groups (-NH₂) of the diamine component and a mole amount of acid anhydride groups (-CO-O-CO-) of the acid dianhydride component are, for example, an equal amount.

Next, a method for producing a porous polyimide film 1 is described with reference to FIG. 1.

In this method, for example, first, a substrate film 2 made of a metal (parentheses and phantom line) is prepared. The substrate film 2 extends in the plane direction. Examples of the metal include copper, iron, silver, gold, aluminum, nickel, and alloys of these (stainless steel and bronze). As the metal, preferably, copper is used. The substrate film 2 has a thickness of, for example, 0.1 µm or more, preferably 1 µm or more, and for example, 100 µm or less, preferably 50 µm or less.

Next, a varnish containing a precursor of a polyimide resin, a porosity forming agent, a nucleating agent, and a solvent is prepared, and then, the varnish is applied to one surface in the thickness direction of the substrate film 2 to form a coating film. A kind, a mixing ratio, and the like of the porosity forming agent, the nucleating agent, and the solvent in the varnish are, for example, described in WO2018/186486.

The precursor of the polyimide resin is a reaction product of the diamine component and the acid dianhydride component described above. To prepare the precursor of the polyimide resin, the above-described diamine component, the above-described acid dianhydride component, and a solvent are blended to prepare a varnish, and the varnish is heated to prepare a precursor solution. Subsequently, a nucleating agent and a porosity forming agent are blended into the precursor solution to prepare a porous precursor solution.

Thereafter, the porous precursor solution is applied to one surface in the thickness direction of the substrate film 2 to form a coating film.

Thereafter, the coating film is dried by heating to form a precursor film. By the above-described heating, the precursor film having a phase separation structure of a polyimide resin precursor and the porosity forming agent with the nucleating agent as a core is prepared, while the removal of the solvent proceeds.

Thereafter, for example, the porosity forming agent is extracted (pulled out or removed) from the precursor film by a supercritical extraction method using supercritical carbon dioxide as a solvent.

Thereafter, the precursor film is cured by heating to form the porous polyimide film 1 made of the polyimide resin. The porous polyimide film 1 is formed on one surface in the thickness direction of the substrate film 2.

Thereafter, if necessary, as shown by a solid line of FIG. 1. the substrate film 2 is removed. For example, the substrate film 2 is dissolved using a stripping solution. An example of the stripping solution includes FeCl₃. Thus, the porous polyimide film 1 is obtained. To produce a metal layer laminate board 10 to be described later, the above-described substrate film 2 is not removed and left as a first metal layer 3.

### <Application>

Next, as shown by a phantom line and the solid line of FIG. 1, the metal layer laminate board 10 including the porous polyimide film 1 is described. The metal layer laminate board 10 includes the porous polyimide film 1 and two metal layers 3 and 4 shown by the phantom line.

The porous polyimide film 1 is provided in the metal layer laminate board 10. That is, the porous polyimide film 1 is used for lamination of the two metal layers 3 and 4 to be described next.

The two metal layers 3 and 4 include the first metal layer 3 and a second metal layer 4. The first metal layer 3 is disposed on the other surface in the thickness direction of the porous polyimide film 1. Examples of a material for the first metal layer 3 include metals illustrated in the substrate film 2. Preferably, copper is used. The first metal layer 3 has a thickness of, for example, 0.1 µm or more, preferably 1 µm or more, and for example, 100 µm or less, preferably 50 µm or less.

The second metal layer 4 is disposed on one surface in the thickness direction of the porous polyimide film 1. The second metal layer 4 may be also disposed on one surface in the thickness direction of the porous polyimide film 1 via an adhesive layer which is not shown. Examples of a material for the second metal layer 4 include metals illustrated in the substrate film 2. A thickness of the second metal layer 4 is the same as that of the first metal layer 3.

A method for producing the metal layer laminate board 10 is described. First, the second metal layer 4 is disposed on one surface in the thickness direction of a laminate 20 which is in the middle of production and includes the substrate film 2 and the porous polyimide film 1. On the other hand, since the substrate film 2 is made of a metal, it is left as it is as the first metal layer 3 (is diverted to the first metal layer 3). Thus, the metal layer laminate board 10 including the porous polyimide film 1, and the second metal layer 4 and the first metal layer 3 disposed on one surface and the other surface, respectively, in the thickness direction thereof is obtained.

Thereafter, the first metal layer 3 and the second metal layer 4 are, for example, formed into a pattern by etching and the like.

The metal layer laminate board 10 is pressed before, during and/or after the formation of the above-described pattern in accordance with its application and purpose. Specifically, the metal layer laminate board 10 is thermally pressed.

The metal layer laminate board 10 is, for example, used for wireless communication of the fifth generation (5G) standard, and/or a high-speed flexible printed board (FPC).

### <Function and Effect of One Embodiment>

In the porous polyimide film 1, the difference between the dielectric loss tangent T2 after immersion in water and the dielectric loss tangent T1 after being left to stand under an atmosphere is 0.0030 or less. Therefore, it is possible to suppress an increase in the dielectric loss tangent even when the porous polyimide film 1 is immersed in water. As a result, the porous polyimide film 1 is used for applications requiring water resistance.

Further, when the dielectric loss tangent T2 of the porous polyimide film 1 after immersion in water is 0.0060 or less, the porous polyimide film 1 is preferably used for applications requiring water resistance.

Further, when the judgement when the porous polyimide film 1 is subjected to the flame retardancy test according to the UL94 standard is V-0 or more, the porous polyimide film 1 has excellent flame retardancy.

### Examples

Next, the present invention is further described based on Examples and Comparative Example below. The present invention is however not limited by these Examples and Comparative Example. The specific numerical values in mixing ratio (content ratio), property value, and parameter used in the following description can be replaced with upper limit values (numerical values defined as "or less" or "below") or lower limit values (numerical values defined as "or more" or "above") of corresponding numerical values in mixing ratio (content ratio), property value, and parameter described in the above-described "DESCRIPTION OF

### EMBODIMENTS".

### <Example 1>

A reaction device equipped with a stirrer and a thermometer was charged with 64.88 g (0.60 mol) of PDA (second aromatic diamine), 40.05 g (0.20 mol) of ODA (third aromatic diamine), and 45.65 g (0.20 mol) of APAB (aromatic diamine represented by formula (1) and in which Y is -COO-); and 2300 g of an N-methyl-2-pyrrolidone (NMP) as a solvent was added thereto and stirred at 40°C for 20 minutes to prepare an NMP solution of PDA, ODA and APAB. The NMP solution contained 1.00 mol of a diamine component.

Next, 294.2 g (1.00 mol) of a 3,3'-4,4'-biphenyltetracarboxylic acid dianhydride (BPDA) was gradually added to the above-described NMP solution, furthermore, 18 g of an N-methyl-2-pyrrolidone (NMP) was added to increase the temperature to 80°C, and thereafter, the resulting mixture was stirred for 10 hours to obtain a polyimide precursor solution.

As a nucleating agent, 3 parts by mass of a PTFE powder having a median diameter of 1 µm or less; as a porosity forming agent, 150 parts by mass of a polyoxyethylene dimethyl ether having a weight average molecular weight of 400 (manufactured by NOF CORPORATION, grade: MM400); and 4 parts by mass of a 2-methylimidazole (manufactured by SHIKOKU CHEMICALS CORPORATION, 2Mz-H) were added to 100 parts by mass of the solid content of the polyimide precursor solution to obtain a porous precursor solution. The obtained porous precursor solution was applied to the substrate film 2 made of copper to form a coating film. Thereafter, the coating film was dried at 135°C for 15 minutes to fabricate a precursor film.

By immersing the precursor film into carbon dioxide pressurized to 30 MPa at 60°C and by circulating it for four hours, extraction removal of the porosity forming agent, phase separation of the remaining NMP, and formation of pores were promoted. Thereafter, the carbon dioxide was reduced in pressure.

Subsequently, the precursor film was heated at a temperature of 390°C for about 185 minutes under vacuum to promote removal and imidization of the remaining component, thereby obtaining the porous polyimide film 1 disposed on one surface in the thickness direction of the substrate film 2. Thereafter, the substrate film 2 and the porous polyimide film 1 (the laminate 20) were immersed in a FeCl₃ solution, and the substrate film 2 was removed.

In Table 1, the number of g and the number of parts by mass of each component are described. In Table 2, the mole fractions of the diamine component and the acid dianhydride component are described.

### <Examples 2 to 4 and Comparative Example 1>

The porous polyimide film 1 was produced in the same manner as in Example 1. However, the formulation was changed in accordance with Tables 1 and 2. In Table 1, DMAc is a dimethylacetamide as a solvent.

### <Evaluation>

The following items were measured for each of the porous polyimide films 1 of Examples 2 to 4 and Comparative Example 1. The results (excluding an average porosity) are described in Table 2.

### <Dielectric Loss Tangent T1>

The dielectric loss tangent T1 of the porous polyimide film 1 was measured. Specifically, the porous polyimide film 1 immediately after production was left to stand for 24 hours under an atmosphere of 25°C and relative humidity of 50%. Thereafter, the porous polyimide film 1 was measured at a frequency of 10 GHz with a resonator.

### <Dielectric Loss Tangent T2>

The dielectric loss tangent T2 of the porous polyimide film 1 was measured. Specifically, the porous polyimide film 1 immediately after production was immersed in water for 24 hours under an atmosphere of 25°C. Thereafter, the porous polyimide film 1 was measured at a frequency of 10 GHz with a resonator.

### <Dielectric Loss Tangent T0>

A dielectric loss tangent T0 of the porous polyimide film 1 immediately after production of Example 1 was measured. As a result, it was confirmed that the dielectric loss tangent T0 of the porous polyimide film 1 immediately after production and the dielectric loss tangent T1 of the porous polyimide film 1 after being left to stand for 24 hours after production were the same.

### <Dielectric Constant>

A dielectric constant of the porous polyimide film 1 immediately after production was measured at a frequency of 10 GHz with a resonator.

### <Porosity>

A porosity of the porous polyimide film 1 was determined by inserting the dielectric constant obtained as the description above into the following formula.

Dielectric constant of porous polyimide film= dielectric constant of air× porosity+ dielectric constant of polyimide resin× (1- porosity)

### <Average Pore Size>

An average pore size of each of the porous polyimide films 1 of Example 1 and Comparative Example 1 was measured by image analysis of a cross-sectional SEM image.

As a result, the porous polyimide film 1 of Example 1 had an average pore size of 3.6 µm. On the other hand, the porous polyimide film 1 of Comparative Example 1 had an average pore size of 5.3 µm.

### <Flame Retardancy Test>

The porous polyimide film 1 was subjected to a flame retardancy test according to the UL94 standard. The judgement obtained in the test was evaluated based on the following criteria:
Good: judged as V-0 or more
Bad: not judged as V-0 or more.

**[Table 1]**

| Table 1 | | | | | | | | |
|---|---|---|---|---|---|---|---|---|
| Mixing Content | | | | Ex.1 | Ex.2 | Ex. 3 | Ex.4 | Comparative Ex. 1 |
| Diamine Component | Main Component | Aromatic Diamine | APAB (g) | 45.65 | - | - | - | - |
| | | Aliphatic Diamine | PRIAMINE 1075 (g) | - | 21.4 | 10.7 | - | - |
| | | | PRIAMINE 1074 (g) | - | - | - | 2.79 | - |
| | Secondary Component | Second Aromatic Diamine | PDA (g) | 64.88 | 1 7.3 | 1 9.4 7 | - | 129.77 |
| | | Third Aromatic Diamine | ODA (g) | 40.05 | - | - | - | 60.07 |
| | | | Tolidine (g) | - | - | - | 1 3.52 | - |
| Acid Dianhydride Component | | Biphenyltetracarboxylic Acid Dianhydride | BPDA (g) | 294.22 | 58.84 | 58.84 | 4.06 | 441.33 |
| | | Benzenetetracarboxylic Acid Dianhydride | PMDA (g) | - | - | - | 12.02 | - |
| Solvent | | | NMP (g) | 2300 | 505 | 460 | - | 3264 |
| | | | DMAc (g) | - | - | - | 1 68 | - |
| Porosity Forming Agent | | | Polyoxyethylene Dimethyl Ether (Number of parts by mass to 100 parts of Solid Contentof Polyimide Precursor Solution | 150 | 120 | 120 | 120 | 200 |

**[Table 2]**

| Table 2 | | | | | | | | |
|---|---|---|---|---|---|---|---|---|
| | | | | Ex. 1 | Ex. 2 | Ex. 3 | Ex. 4 | Comparative Ex. 1 |
| Diamine Component | Main Component | Aromatic Diamine | APAB (mol% ) | 20 | - | - | - | - |
| | | Aliphatic Diamine | PRIAMINE 1075 (mol% ) | - | 20 | 10 | - | - |
| | | | PRIAMINE 1074 (mol% ) | - | - | - | 10 | - |
| | Secondary Component | Second Aromatic Diamine | PDA (mol% ) | 60 | 80 | 90 | - | 80 |
| | | Third Aromatic Diamine | ODA (mol% ) | 20 | - | - | - | 20 |
| | | | Tolidine (mol% ) | - | - | - | 90 | - |
| Acid Dianhydride Component | | Biphenyltetracarboxylic Acid Dianhydride | BPDA (mol% ) | 100 | 100 | 100 | 20 | 100 |
| | | Benzenetetracarboxylic Acid Dianhydride | PMDA (mol% ) | - | - | - | 80 | - |
| Porosity (% ) | | | | 69 | 69 | 61 | 55 | 81 |
| Dielectric Constant | | | | 1.70 | 1.67 | 1.93 | 1.97 | 1.49 |
| Dielectric Loss Tangent | | | T0 (Immediately after Production) | 0.0038 | - | - | - | - |
| | | | T1 (Left to Stand under Atmosphere for 24 Hours after Production) | 0.0022 | 0.0005 | 0.001 9 | 0.0027 | 0.0029 |
| | | | T2 (Immersion in Water for 24 Hours after Production) | 0.0038 | 0.0015 | 0.0039 | 0.0044 | 0.0060 |
| Difference of Dielectric Loss Tangent | | | T2-T1 | 0.001 6 | 0.001 1 | 0.0020 | 0.001 8 | 0.0031 |
| Flame Retardancy | | | UL94 V-0 | Good | Bad | Bad | Bad | Good |

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

### Description of Reference Numerals

- 1: Porous polyimide film

## Claims

1. A porous polyimide film having a difference between a dielectric loss tangent T1 after being left to stand for 24 hours under an atmosphere of 25°C and relative humidity of 50% and a dielectric loss tangent T2 after immersion in water for 24 hours under an atmosphere of 25°C of 0.0030 or less.

2. The porous polyimide film according to claim 1 having
the dielectric loss tangent T2 of 0.0060 or less.

3. The porous polyimide film according to claim 1 or 2, wherein
a judgement in a flame retardancy test according to the UL94 standard is V-0 or more.
